# EUROPEAN PATENT APPLICATION

(11) **EP 3 305 940 A1**
(43) Date of publication of application: **11.04.2018**
(21) Application number: 17195168.4
(22) Date of filing: 06.10.2017
(51) Int. Cl.: C23C 16/458

(54) **SUSCEPTOR**

(30) Priority: 06.10.2016 JP 2016197879
(71) Applicant: CoorsTek KK, Tokyo 141-0032 (JP)
(72) Inventor: IKEDA, Shoto, Yamagata, 999-1351 (JP); SUZUKI, Kenji, Yamagata, 999-1351 (JP); UMETSU, Hiroyuki, Kanagawa, 257-8566 (JP); YOKOGAWA, Masanari, Yamagata, 999-1351 (JP)
(74) Representative: Hoffmann Eitle

(57) **Abstract**

A susceptor has a circular concave recess formed on an upper surface of a circular plate and holds a substrate to be processed such as a silicon wafer in the recess. The susceptor includes a non-constant height periphery around the recess, and the periphery is inclined toward the recess along a radial direction from an outer peripheral end to an inner peripheral end of the periphery. The susceptor allows to suppress variation in film thickness of a formed film on the substrate to be processed.

## Description

### BACKGROUND OF THE INVENTION

### Field of the Invention

The present invention relates to a susceptor that holds a substrate to be processed such as a silicon wafer, and relates to, for example, a susceptor that is used in an apparatus for depositing a film by chemical vapor deposition process onto a held silicon wafer.

### Description of the Related Art

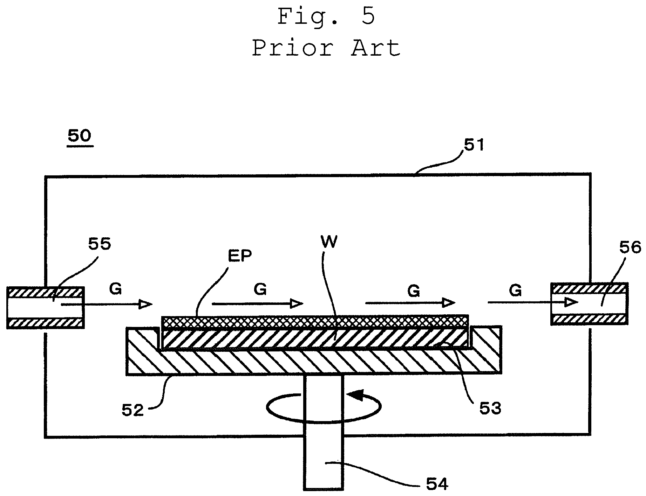

There is a process of forming an epitaxial film on an upper surface of a silicon wafer as a pretreatment for forming a semiconductor circuit on a silicon wafer. As schematically illustrated in FIG. 5, a silicon wafer W is mounted on a susceptor 52 equipped inside a chamber 51 of a vapor-phase epitaxy growth apparatus 50 with which an epitaxial film EP is to be deposited on an upper surface of the silicon wafer W. Then, the susceptor 52 and the silicon wafer W are rotated around a rotation shaft 54 in a predetermined direction. At this time, a reaction gas G is horizontally supplied from a reaction gas supply pipe 55 toward an exhaust pipe 56 while heating the silicon wafer W using a heater (not shown) outside the chamber. Thus, the epitaxial film EP is formed on the surface of the silicon wafer W by vapor phase deposition.

Meanwhile, a mounting portion of the silicon wafer W is a circular concave portion (referred to as a recess 53) formed on a central portion of the upper surface of the susceptor 52 as illustrated in FIG. 5. The recess 53 is formed of a circular bottom wall and a sidewall surrounding the bottom wall. The bottom wall has a flat or slightly curved shape (flat in FIG. 5), and the sidewall is formed by vertically grinding the upper surface of the susceptor 52 to a predetermined depth.

In inventions disclosed in JP 2006-41028 A and JP 2010-40607 A, a process of forming a film on a silicon wafer is improved by devising a shape of a susceptor that includes such a recess.

Meanwhile, it is required to reduce a variation in film thickness of the epitaxial film EP on a plane of the silicon wafer in order to form a favorable semiconductor circuit.

However, there is a case where the wafer surface is not horizontally held at the time of holding the silicon wafer W on the recess 53. When the reaction gas G is supplied to the silicon wafer W that is rotating in a not-horizontally mounted state, there arises a problem that the wafer surface is not uniformly exposed to the reaction gas G so that variations occur in the deposited film thickness.

Conventionally, it has been considered that depth of the recess 53 on which the silicon wafer W is mounted, flatness and evenness of a contact portion (bottom wall) which is in contact with the silicon wafer W, and the like are important in order to solve the above-described problem.

However, a problem arises that variations occur in the film thickness of the epitaxial film between susceptors, even if the parameters such as the depth, and the flatness and evenness of the contact portion of the recess formed in the susceptor are the same.

In order to solve the above-described problems, the present inventors have further conducted extensive research, and as a result, found that an inclination from an outer peripheral end of the susceptor to a recess end is related to the variation in film thickness of the epitaxial film, thereby devising the present invention.

### SUMMARY OF THE INVENTION

An object of the present invention is to provide a susceptor that holds a substrate to be processed such as a silicon wafer, the susceptor being capable of achieving to form a uniform film on the substrate to be processed by suppressing a variation in film thickness.

In order to achieve the above-described object, the susceptor according to the present invention is a susceptor which has a circular concave recess formed on an upper surface of a circular plate and which holds a substrate to be processed in the recess. The susceptor has a protruding periphery around the recess, and the surface of the periphery is inclined toward the recess along a radial direction from an outer peripheral end to an inner peripheral end of the peripheral edge portion.

A first inclination, which is inclined to the recess along the radial direction from an outer peripheral end to an inner peripheral end of the periphery, is desirably 0. 003 rad or more and 0.01 rad or less.

In addition, a surface opposite to a surface where the recess is formed is desirably inclined toward the recess along the radial direction from an outer peripheral end to a position corresponding to an inner peripheral end of the periphery.

In addition, a second inclination, which is inclined toward the recess along the radial direction from the outer peripheral end to the position corresponding to the inner peripheral end of the peripheral edge portion on the surface opposite to the surface where the recess is formed, is desirably 0.0005 rad or more and 0.005 rad or less.

In addition, it is desirable that a base material has a circular concave recess formed on the upper surface of the circular plate, the protruding periphery around the recess, upper and lower surfaces of the periphery are formed to be flat, and a coating film is formed on the base material such that an inclination at the periphery is formed by varying a thickness of the coating film.

In addition, the variation of the first inclination in the circumferential direction is desirably equal to 0.005 rad or less.

In a film deposition process to substrates to be processed with thus configured susceptor, since the inclination of the upper surface of the periphery of the susceptor enables to regulate a flow of the reaction gas to the substrate, the entire surface of the substrate is exposed to the reaction gas, even if the substrate surface is not horizontally held, whereby a deposited film thickness can be made uniform.

In addition, since the lower surface of the periphery is inclined, the reaction gas flows to the entire lower surface of the susceptor, and temperature uniformity of the susceptor is improved. As a result, it is possible to further improve the film thickness uniformity of the film deposited on the substrate to be processed.

### BRIEF DESCRIPTION OF THE DRAWING

FIG. 1 is a cross-sectional view of a susceptor according to the present invention;
FIG. 2 is a plan view of the susceptor according to the present invention;
FIG. 3 is an enlarged cross-sectional view illustrating a periphery of the susceptor of FIG. 1;
FIG. 4 is a cross-sectional view for describing a process of mounting a silicon wafer on a surface of a recess of the susceptor of FIG. 1 and forming a film by chemical vapor deposition; and
FIG. 5 is a cross-sectional view of a conventional vapor deposition apparatus.

### DESCRIPTION OF THE PREFERRED EMBODIMENTS

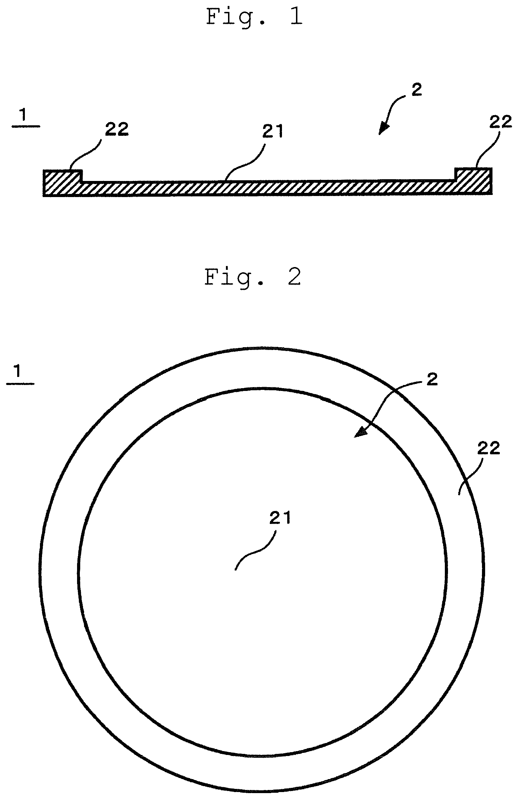

Hereinafter, an embodiment will be described with reference to the drawings. FIG. 1 is a cross-sectional view of a susceptor according to the present invention, and FIG. 2 is a plan view of the susceptor according to the present invention. It should be noted that the drawings are schematic or conceptual, and a relationship between a thickness and a width of each portion, a ratio of sizes between the portions, and the like are not accurately illustrated.

As illustrated in FIGS. 1 and 2, a susceptor 1 has a circular plate shape, and a wafer mounting portion 2 on which one silicon wafer (substrate to be processed) is mounted is formed on an upper surface of the susceptor. That is, the susceptor 1 is configured to perform processing the silicon wafer in a single-wafer processing method.

The wafer mounting portion 2 has a recess 21, which is formed in a circular concave shape in which the silicon wafer is held, and a periphery 22 that is formed to be higher stepwisely around the recess 21.

A diameter of the recess 21 is formed to be slightly larger than a diameter of the silicon wafer so that the silicon wafer fits into the recess 21. In addition, a depth of the recess 21 is formed to be a depth at the same level of a thickness of the silicon wafer to be processed.

Incidentally, loading and unloading of the silicon wafer with respect to the recess 21 of the wafer mounting portion 2 can be carried out, for example, by lifting or lowering the silicon wafer with a plurality of lifting pins (not shown) that advance upward and retract downward through penetrating holes formed in a bottom surface of the recess 21.

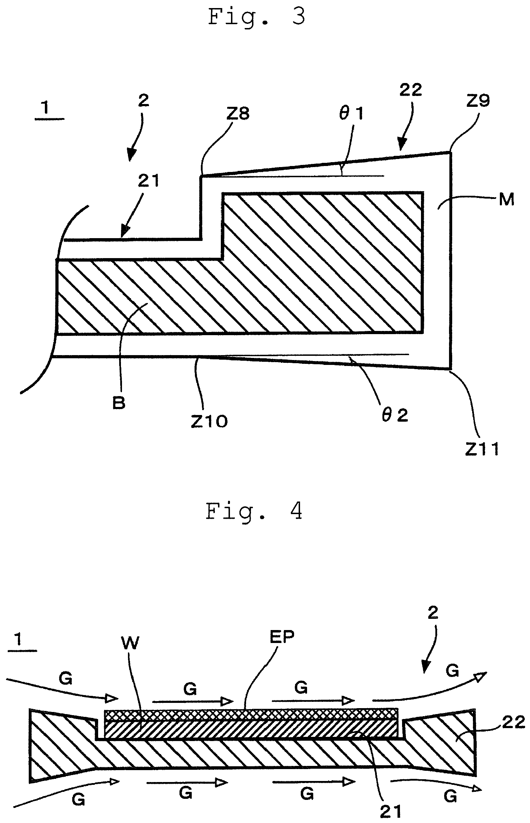

FIG. 3 is an enlarged cross-sectional view illustrating the periphery 22 of the susceptor 1 of FIG. 1. As illustrated in FIG. 3, upper and lower surfaces of the periphery 22 of the susceptor 1 are inclined.

Specifically, the upper surface of the periphery 22 is inclined to the recess 21 (lower side) toward a radially inner side, and a first inclination θ1 from an outer peripheral end Z9 to an inner peripheral end Z8 of the periphery 22 is formed to be 0.003 rad or more and 0.01 rad or less.

In an epitaxial film growth processing to the silicon wafer W held in the recess 21 as shown in FIG. 4, a reaction gas supplied horizontally flows along the inclination of the periphery 22, since the upper surface of the periphery 22 of the susceptor 1 is inclined to the recess 21 (lower side) toward the radially inner side. Then, this configuration causes the reaction gas G to flow uniformly toward the entire surface of the silicon wafer W, thereby reducing variations in film thickness of the epitaxial film.

In addition, the lower surface (surface opposite to the surface where the recess 21 is formed) of the periphery 22 is inclined to the recess 21 (a back surface side of the recess 21) toward the radially inner side. As illustrated in FIG. 3, a second inclination θ2 from an outer peripheral end Z11 to a position Z10 corresponding to an inner peripheral end of the periphery 22 is formed to be 0.0005 rad or more and 0.005 rad or less.

Since the inclination is made on the lower surface side of the periphery 22 to the recess 21 (the back side of the recess 21) toward the radially inner side, it allows the reaction gas G to flow along the inclination of the periphery 22, and the entire lower surface of the susceptor 1 to be exposed to the reaction gas G. Thus, the temperature uniformity of the susceptor 1 to be improved. As a result, the uniformity of the film thickness of the epitaxial film formed on the silicon wafer W is further improved.

Further, a variation of the first inclination θ1 along the circumferential direction is set to fall within a range of 0 to 0.005 rad. When the variation of the first inclination in the circumferential direction is reduced in this manner, it is possible to suppress a difference in height of the epitaxial film.

In addition, a variation of the second inclination θ2 in the circumferential direction is set to fall within the range of 0 to 0.005 rad. This makes it possible to expect regulation of a source gas flowing to the lower surface part of the susceptor and to more easily control the difference in height of the epitaxial film through the first inclination in the circumferential direction.

As illustrated in FIG. 3, the susceptor 1 having the inclination at the periphery 22 as described above can be obtained by depositing a silicon carbide (SiC) coating film M using chemical vapor deposition (CVD) to a regular disk-shaped carbon base material B having a recess formed at a center portion. In particular, it is possible to make the inclination during the formation of the SiC coating film to the periphery 22 of the susceptor by changing a thickness of the SiC coating film in the radial direction.

CVD coating conditions to form the SiC coating film on the surface of the carbon base material are: pressure in a furnace inside a chamber is 15 to 25 Pa, and temperature of the furnace is maintained at 1700°C or higher and 1780°C or lower and a gas flow duration is 20 hours or more. In order to make a uniform film formation, CVD coating is performed while rotating the carbon base material B in the circumferential direction. In addition, it is possible to adjust a thickness of the SiC film and the inclination of the periphery 22 of the susceptor by controlling the flow of the source gas applied to the carbon base material B to hit the periphery 22 of the susceptor more than the other portions using a jig or the like.

To grow an epitaxial film on an upper surface of a silicon wafer W using the thus configured susceptor 1, the silicon wafer W is mounted onto the surface of the recess 21 of the susceptor 1, as illustrated in FIG. 4, inside the chamber (not shown).

Further, the silicon wafer W is heated by a heater (not shown) provided outside the chamber while rotating the susceptor 1 and the silicon wafer W thereon in a predetermined direction at predetermined speed as illustrated in FIG. 5. Then, through the reaction between a reaction gas that is horizontally introduced into the chamber and the heated surface of the silicon substrate, an epitaxial film grows on the upper surface of the silicon wafer W by a chemical vapor growth process.

In this film formation process, the flow of the reaction gas G toward the silicon wafer W surface is genereated due to the inclination of the upper surface of the periphery 22 of the susceptor 1, and the reaction gas G hits the entire wafer surface even if the wafer surface is not held horizontally. Thus, it is possible to make the film thickness of the formed epitaxial film uniform.

In addition, since the lower surface of the periphery 22 is inclined, the reaction gas G flows beneath the entire lower surface of the susceptor 1, and the temperature uniformity of the susceptor 1 is improved. As a result, the uniformity of the film thickness of the epitaxial film formed on the silicon wafer W can be further improved.

Hereinafter, the present invention will be described more specifically based on examples, but the present invention is not limited by the following examples.

In the present examples, the SiC coating film is formed on the surface of the carbon base material to form the inclination on the periphery (on upper and lower surfaces) of the susceptor. The periphery is an annular portion which is formed to be a stepwise protruding structure whose height increase as goes to the edge around the recess 21 as described in the embodiment.

The carbon base material of a complete disk shape is used, having a circular concave recess formed at the center portion of the upper surface. In the present examples, a susceptor for a wafer of 300 mm in diameter was used, the recess end was set at a position of R =175 mm, and the outer peripheral end of the susceptor was set at a position of R =185 mm from the center of the susceptor.

In addition, an epitaxial film was formed on a silicon wafer using the prepared susceptor in each of the examples with an inclination (in rad) of the periphery of the susceptor as a condition of the example, and a film formation state thereof was evaluated. The other conditions and evaluation results of the examples are shown in Table 1.

As shown in Table 1, a contact-type three-dimensional measuring instrument was used for measurement of the inclination (in rad) of the prepared susceptor; the height was measured from an outer peripheral end to a recess end of an upper face (recessed surface) of the susceptor, assuming a surface plate to be flat. The inclination was obtained using the height data and a difference of distances to the center. The inclination was obtained for a back surface in the same manner as that for the recess surface.

In addition, in the film formation evaluation results are shown in the table; "Good" indicates that the film thickness of the epitaxial film formed on the silicon wafer was uniform (a variation in film thickness inside a wafer surface was within ± 2% with respect to a film thickness X), "Fair" indicates that the variation somewhat occurred in the film thickness (the variation in film thickness inside the wafer surface was within the range of ±2% < X < ±4% with respect to the film thickness X), and "Bad" indicates that the variation greatly occurred in the film thickness (the variation in film thickness inside the wafer surface was ± 4% or more with respect to the film thickness X).

**Table 1**

| | First inclination (rad) from outer peripheral end of susceptor to recess end | Second inclination (rad) from outer peripheral end of lower surface of susceptor to position corresponding to recess end | Variation (rad) of first inclination in circumferential direction | Film formation evaluation result |
|---|---|---|---|---|
| Example 1 | 0.00263 | 0.00213 | 0.002617 | Fair |
| Example 2 | 0.00304 | 0.00301 | 0.003769 | Good |
| Example 3 | 0.01158 | 0.00273 | 0.003286 | Good |
| Example 4 | 0.01733 | 0.00405 | 0.002348 | Fair |
| Example 5 | 0.00334 | 0.00043 | 0.004321 | Fair |
| Example 6 | 0.00832 | 0.00049 | 0.003782 | Good |
| Example 7 | 0.00745 | 0.00343 | 0.003245 | Good |
| Example 8 | 0.00542 | 0.00523 | 0.003232 | Good |
| Example 9 | 0.00632 | 0.00631 | 0.004393 | Fair |
| Example 10 | 0.01645 | 0.00834 | 0.005224 | Bad |
| Example 11 | 0.00352 | 0.00335 | 0.005213 | Fair |
| Example 12 | 0.01102 | 0.00082 | 0.005899 | Fair |
| Comparative Example 1 | 0.00034 | 0.00021 | 0.000126 | Fair |

As seen in the results of Examples 1 to 12, the result of film formation on the silicon wafer was favorable when the first inclination from the outer peripheral end of the susceptor to the recess end was in the range of 0.003 rad to 0.01 rad.

In addition, the result of film formation was favorable when the second inclination from the outer peripheral end of the lower surface of the susceptor to the position corresponding to the recess end was in the range of 0.0005 rad to 0.005 rad as in Examples 2, 3, 6, 7, and 8.

In addition, it is also seen that favorable results were obtained as described above in the case where the variation of the first inclination in the circumferential direction was 0. 005 rad or less although the variation was greater than 0. 005 rad in both Examples 11 and 12.

From the results of the examples described above, it is confirmed that it is possible to suppress the variation in film thickness and make the film uniform by performing the film formation process on the silicon wafer using the susceptor according to the present invention.

## Claims

1. A susceptor which has a circular concave recess formed on an upper surface of a circular plate and which holds a substrate to be processed in the recess, the susceptor comprising
a periphery protruding around the recess,
wherein a top surface of the periphery of the susceptor is inclined toward the recess along a radial direction from an outer peripheral end to an inner peripheral end of the periphery.

2. The susceptor according to claim 1, wherein
a first inclination of the periphery which is inclined toward the recess along the radial direction from the outer peripheral end to the inner peripheral end of the periphery is 0.003 rad or more and 0.01 rad or less.

3. The susceptor according to claim 1, wherein
a surface opposite to the upper surface where the recess is formed is inclined toward the recess along the radial direction from the outer peripheral end to a position corresponding to the inner peripheral end of the periphery.

4. The susceptor according to claim 3, wherein
a second inclination of the surface which is inclined toward the recess along the radial direction from the outer peripheral end to the position corresponding to the inner peripheral end of the periphery on the surface opposite to the surface where the recess is formed is 0.0005 rad or more and 0.005 rad or less.

5. The susceptor according to claim 1, further comprising:
a base material which has the circular concave recess formed on the upper surface of the circular plate;
the periphery of which has a non-constant height around the recess; and
upper and lower surfaces of the periphery formed to be flat; and
a coating film formed on the base material
wherein an inclination at the periphery is formed with a varied thickness of the coating film.

6. The susceptor according to claim 1, wherein
a variation of the first inclination along the circumferential direction is 0.005 rad or less.
